(19) Europäisches Patentamt
European Patent Office
Office européen des brevets

(11) **EP 2 816 368 B1**

(12) **EUROPEAN PATENT SPECIFICATION**

(45) Date of publication and mention
of the grant of the patent:
**22.11.2017 Bulletin 2017/47**

(21) Application number: **13749938.0**

(22) Date of filing: **29.01.2013**

(51) Int Cl.:
*G01R 33/09* (2006.01)       *G01R 33/02* (2006.01)
*H01L 43/02* (2006.01)       *H01L 43/08* (2006.01)
*G07D 7/04* (2016.01)       *G01R 33/00* (2006.01)

(86) International application number:
**PCT/JP2013/051809**

(87) International publication number:
**WO 2013/121870 (22.08.2013 Gazette 2013/34)**

(54) **MAGNETIC SENSOR APPARATUS**

MAGNETSENSORVORRICHTUNG

APPAREIL DE CAPTEUR MAGNÉTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.02.2012   JP 2012028945**

(43) Date of publication of application:
**24.12.2014   Bulletin 2014/52**

(73) Proprietor: **Murata Manufacturing Co., Ltd.
Nagaokakyo-shi, Kyoto 617-8555 (JP)**

(72) Inventor: **MINAMIDANI, Tamotsu
Nagaokakyo-shi
Kyoto 617-8555 (JP)**

(74) Representative: **Reeve, Nicholas Edward
Reddie & Grose LLP
The White Chapel Building
10 Whitechapel High Street
London E1 8QS (GB)**

(56) References cited:
EP-A2- 0 662 667       WO-A1-2010/052797
WO-A1-2012/015012       JP-A- H06 111 251
JP-A- H07 210 833       JP-A- 2012 255 770

**Description**

<u>Technical Field</u>

The present invention relates to a magnetic sensor apparatus including a magnetic sensor for sensing a magnetic pattern on a medium, such as a banknote.

<u>Background Art</u>

A magnetic sensor apparatus including a magnetic sensor that identifies a medium with a magnetic pattern formed by printing using magnetic ink, such as a banknote or security paper is disclosed in Japanese Unexamined Patent Application Publication No. 6-18278

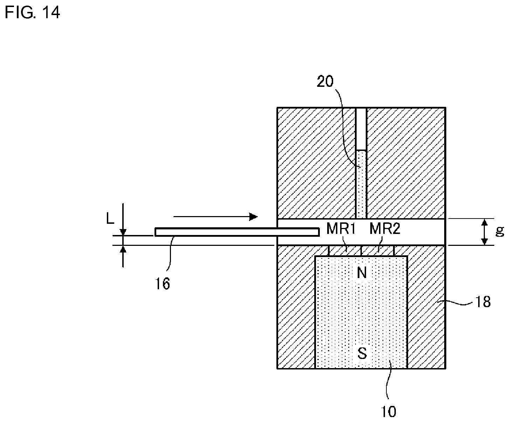

Fig. 14 schematically illustrates a magnetic sensor apparatus described in JP6-18278. The magnetic sensor apparatus includes a magnetic sensor in which magnetic resistance elements MR1 and MR2 are arranged on a magnet 10 and an opposed yoke 20 arranged above the magnetic resistance elements MR1 and MR2. In the magnetic sensor apparatus, a medium 16 with a magnetic pattern that is not illustrated moves between the magnetic sensor and the opposed yoke 20 passes over the magnetic resistance elements MR1 and MR2.

In the magnetic sensor apparatus illustrated in Fig. 14, the opposed yoke 20 is arranged to increase the resolution in the conveying direction of the medium 16. Thus the opposed yoke 20 has an elongated shape that is narrow in the conveying direction of the medium 16. The two magnetic resistance elements MR1 and MR2 are arranged in equal positions with respect to the center of the magnet 10. Thus the magnetic flux divergence is suppressed by the opposed yoke 20, and the resolution is improved.

One of the characteristics required by a magnetic sensor apparatus for identifying a medium with a magnetic pattern formed by printing using, for example, magnetic ink, such as a banknote or security paper, is a so-called output gap characteristic. Normally, when a medium to be sensed is conveyed, an output of the magnetic sensor varies in accordance with the space between the magnetically sensitive portion in the magnetic resistance element and the medium. The relation of the variations in the output of the magnetic sensor to the changes in the space between the magnetically sensitive portion in the magnetic resistance element and the medium is the output gap characteristic. When the variations in the output of the magnetic sensor are small in response to the changes in the space between the magnetically sensitive portion in the magnetic resistance element and the medium, the output gap characteristic is considered good.

In a known typical magnetic sensor, because the magnet constitutes an open magnetic path and the magnetic flux diverges, the magnetic flux density rapidly decreases with an increase in the distance from the magnet. Accordingly, as the space between the magnetically sensitive portion in the magnetic resistance element and the medium increases, the changes in the magnetic flux density above the magnetically sensitive portion in the magnetic resistance element reduces and the output of the magnetic sensor is apt to sharply decrease. Thus it is difficult to obtain a satisfactory output gap characteristic from the known typical magnetic sensor. Magnetic sensors are known from EP0662667, WO2012/015012 and WO2010/052797.

In the magnetic sensor apparatus illustrated in Fig. 14, the opposed yoke 20 is thin, and the effect of suppressing the divergence of the magnetic flux emitting from the magnet 10 is insufficient. Thus a significant improvement in the output gap characteristic is not expected.

To suppress a reduction in the output of the magnetic sensor with a poor output gap characteristic in the magnetic sensor apparatus, a structure may be used in which the space between the magnetically sensitive portion in the magnetic resistance element and the medium is reduced and the medium can be conveyed while that space remains unchanged. For example, the magnetic sensor apparatus may include a structure for conveying the medium by a medium conveyance roller being in contact with the cover of the magnetic sensor while the medium slides on the cover of the magnetic sensor. However, such a structure for conveying the medium is complicated, and the magnetic sensor apparatus including that complicated structure is not suited for conveying a large quantity of media at high speed. There is also a cover wearing-out problem.

We have appreciated that it would be desirable to provide a magnetic sensor apparatus that suppresses variations in the output of a magnetic sensor to changes in the space between a magnetically sensitive portion in a magnetic resistance element and a medium.

SUMMARY OF INVENTION

A magnetic sensor apparatus according to the present invention includes a magnetic sensor and a yoke. The magnetic sensor includes a magnetic resistance element, a magnet, and a holder on which the magnetic resistance element is disposed and that holds the magnet in a position where a magnetic field is applied to the magnetic resistance element. The magnetic sensor is configured to sense a magnetic substance included in a medium. The yoke is arranged in a position opposite to the magnet such that a conveying portion allowing the medium to be conveyed and the magnetic resistance element are disposed therebetween. The yoke has an opposite surface to the magnet, and the magnet has an opposite surface to the yoke, and each of the yoke and the magnet has a widthwise dimension along a conveying direction of the medium, the widthwise dimension of the yoke on the opposite surface to the magnet is larger than the widthwise dimension of the magnet on the opposite surface to the yoke.

In the magnetic sensor apparatus according to the present invention, the opposite surfaces may preferably be parallel to each other, and the magnetic resistance element may preferably be arranged in a position that is central in the conveying direction of the medium between the two opposite surfaces.

In the magnetic sensor apparatus according to the present invention, the holder may preferably hold the yoke.

In the magnetic sensor apparatus according to the present invention, a space from the opposite surface of the yoke to the magnet to the conveying portion may preferably be narrower than a clearance of the conveying portion.

In the magnetic sensor apparatus according to the present invention, the magnet may preferably be a ferrite magnet.

In the magnetic sensor apparatus according to the present invention, a magnetic flux density in a magnetically sensitive portion in the magnetic resistance element may preferably be in a range of 150 to 450 mT.

In the magnetic sensor apparatus according to the present invention, the yoke may preferably be magnetized in a direction in which the yoke and the magnet are attracted to each other.

According to the present invention, because the magnetic flux does not diverge between the magnet and the yoke, the changes in the magnetic flux density to the distance from the magnet are small, and the reduction in the output of the magnetic sensor to the changes in the space between the magnetically sensitive portion in the magnetic resistance element and the medium can be suppressed. Thus a wide clearance is allowed in the conveying path for the medium, the structure for conveying the medium is not complicated, and the magnetic sensor apparatus can also be used in conveying a large quantity of media at high speed.

BRIEF DESCRIPTION OF DRAWINGS

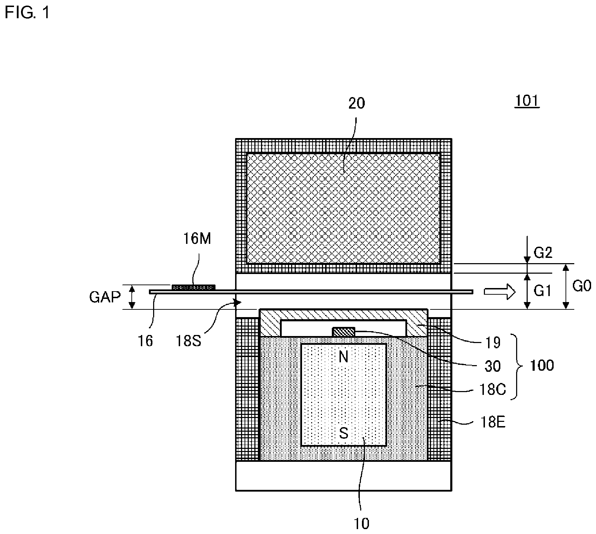

Fig. 1 is a cross-sectional view of a main portion in a magnetic sensor apparatus according to an embodiment of the present invention.

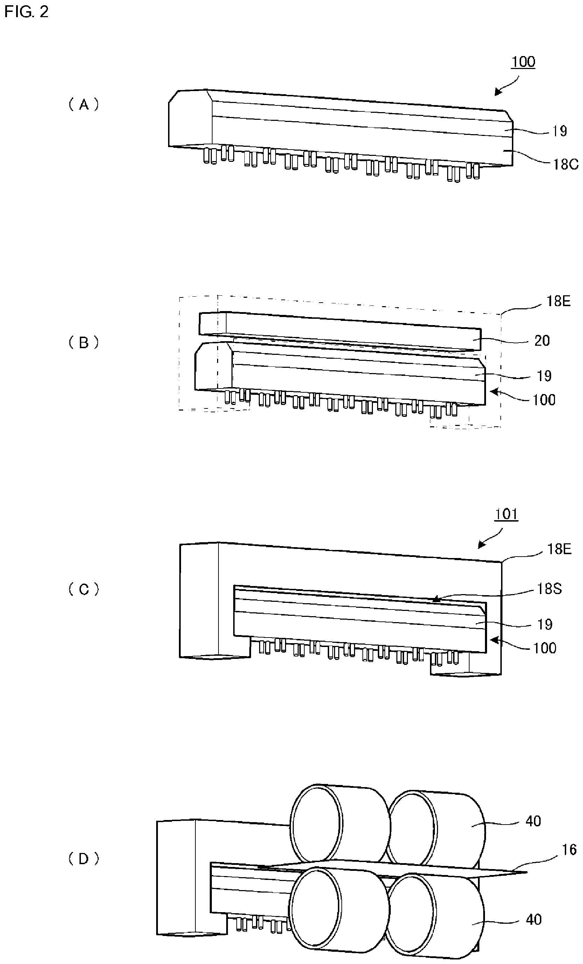

Fig. 2(A) is a perspective view of a magnetic sensor included in the magnetic sensor apparatus according to the embodiment of the present invention. Fig. 2(B) is a transparent perspective view of the magnetic sensor apparatus according to the embodiment of the present invention and illustrates a positional relationship between the magnetic sensor and a yoke. Fig. 2(C) is a perspective view of the magnetic sensor apparatus 101. Fig. 2(D) illustrates a structure for conveying a medium.

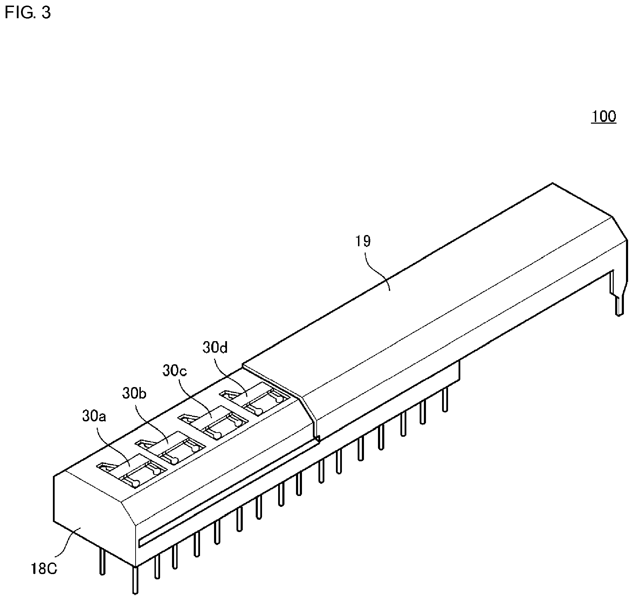

Fig. 3 is a cut-away perspective view of the magnetic sensor included in the magnetic sensor apparatus according to the embodiment of the present invention.

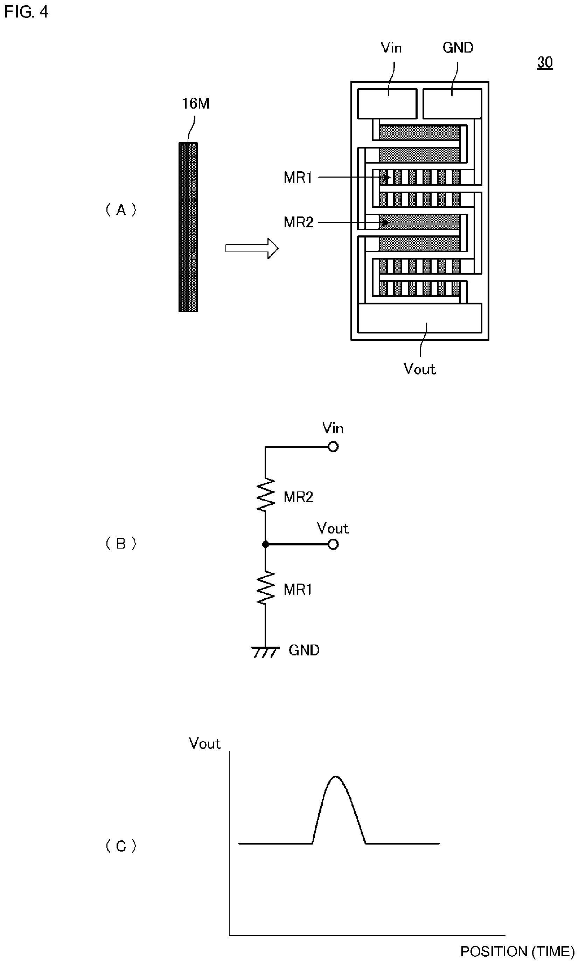

Fig. 4(A) is a plan view of a magnetic resistance element included in the magnetic sensor in the magnetic sensor apparatus according to the embodiment of the present invention. Fig. 4(B) is a circuit diagram of the magnetic sensor included in the magnetic sensor apparatus according to the embodiment of the present invention. Fig. 4(C) is a waveform diagram of an output voltage of the magnetic sensor in the magnetic sensor apparatus according to the embodiment of the present invention when the medium 16 is conveyed.

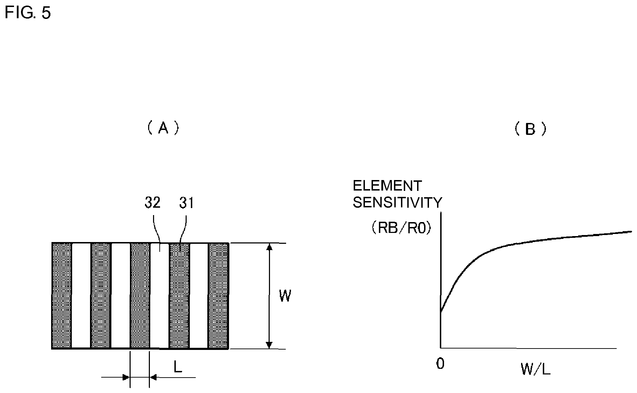

Fig. 5(A) is a plan view that illustrates a configuration of an element MR1 included in the magnetic resistance element according to the embodiment of the present invention. Fig. 5(B) illustrates a characteristic of the change ratio RB/R0 of the resistance value of the element MR1 to W/L where L indicates the pitch of magnetic resistance sections and short bars included in the element MR1 and W indicates the width of each of them.

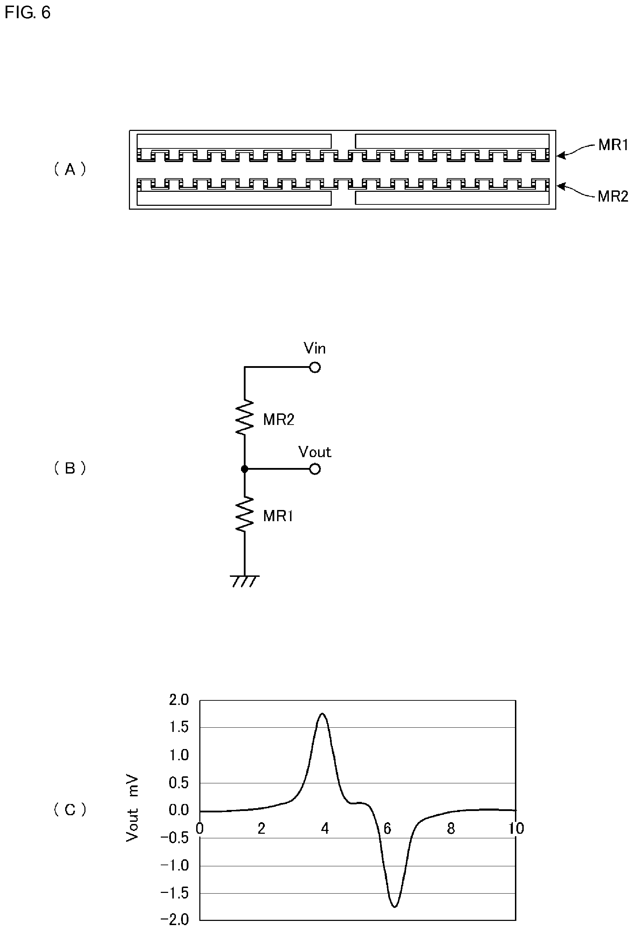

Fig. 6(A) is a plan view of a magnetic resistance element included in a magnetic sensor according to a comparative example. Fig. 6(B) is circuit diagram of the magnetic sensor according to the comparative example. Fig. 6(C) is a waveform output of an output voltage of the magnetic sensor according to the comparative example when a medium is conveyed.

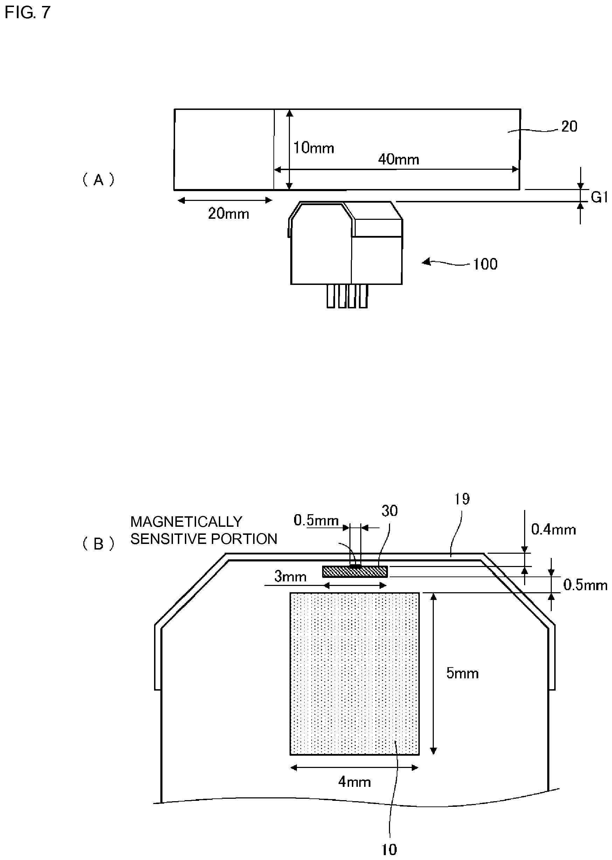

Fig. 7(A) illustrates dimensions of the yoke included in the magnetic sensor apparatus according to the embodiment of the present invention. Fig. 7(B) illustrates dimensions of sections of the magnetic resistance element and a cover included in the magnetic sensor in the magnetic sensor apparatus according to the embodiment of the present invention and a positional relationship among them.

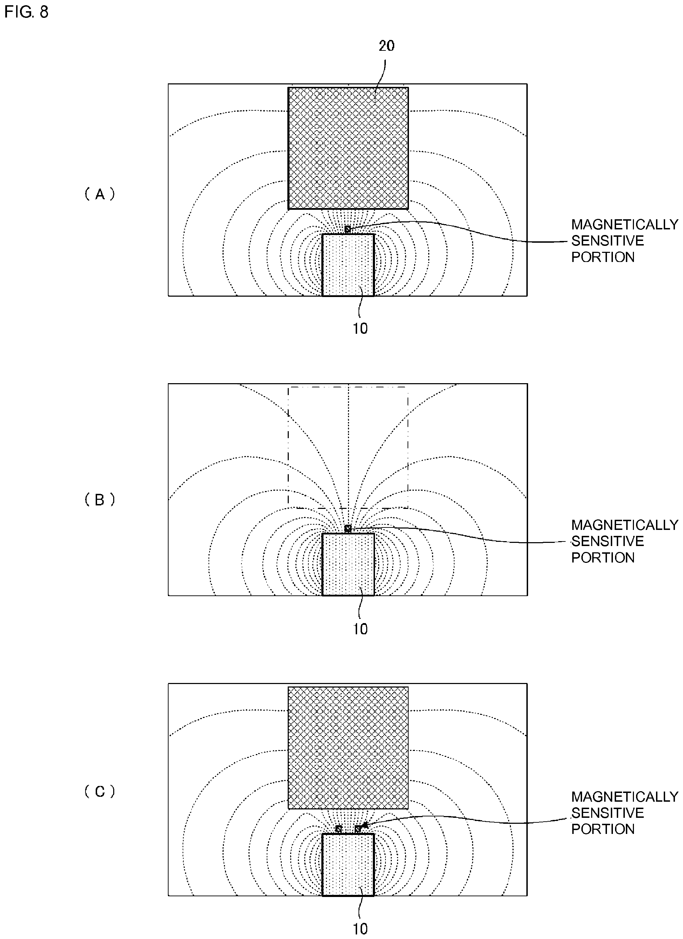

Fig. 8(A) illustrates a strength distribution of a magnetic field in the magnetic sensor apparatus according to the embodiment of the present invention using magnetic lines of force. Fig. 8(B) illustrates a strength distribution of a magnetic field in a magnetic sensor apparatus according to a first comparative example using magnetic liens of force. Fig. 8(C) illustrates a strength distribution of a magnetic field in a magnetic sensor apparatus according to a second comparative example using magnetic liens of force.

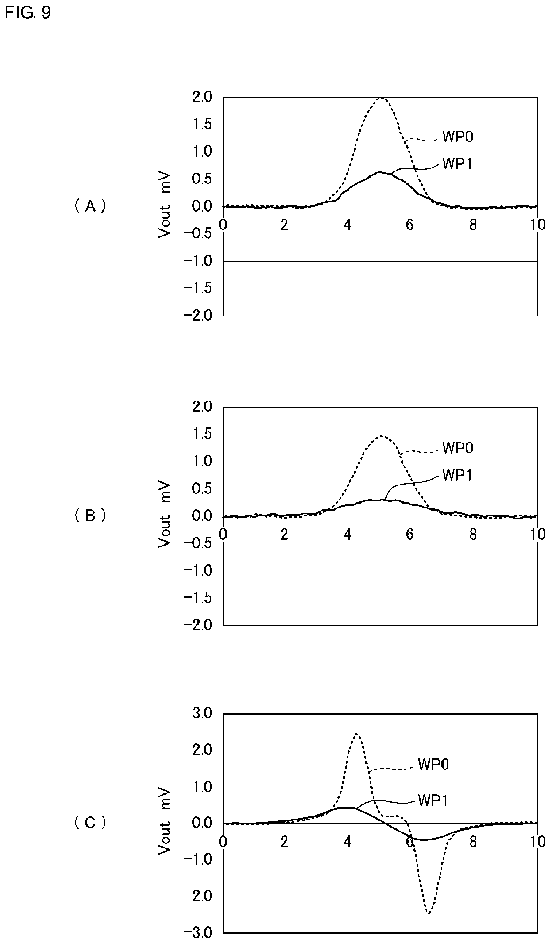

Fig. 9(A) is a waveform diagram of the output voltage of the magnetic sensor when a medium is conveyed in the magnetic sensor apparatus according to the embodiment of the present invention. Fig. 9(B) is a waveform diagram of an output voltage of the magnetic sensor when a medium is conveyed in the magnetic sensor apparatus according to the first comparative example. Fig. 9(C) is a waveform diagram of an output voltage of the magnetic sensor when a medium is conveyed in the magnetic sensor apparatus according to the second comparative example.

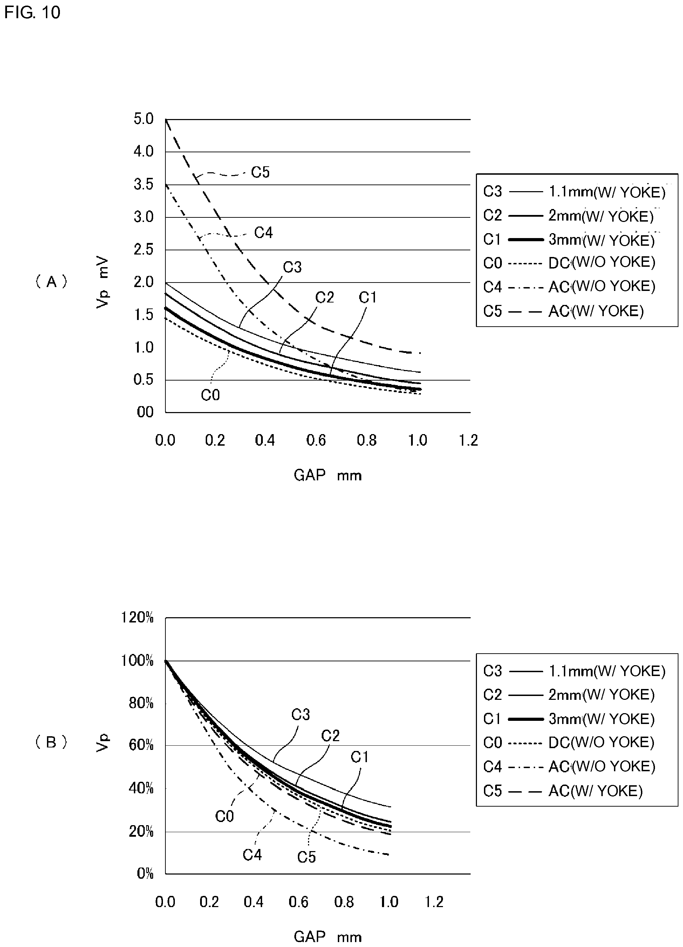

Figs. 10(A) and 10(B) illustrate changes of a peak value of the output voltage of the magnetic sensor to GAP.

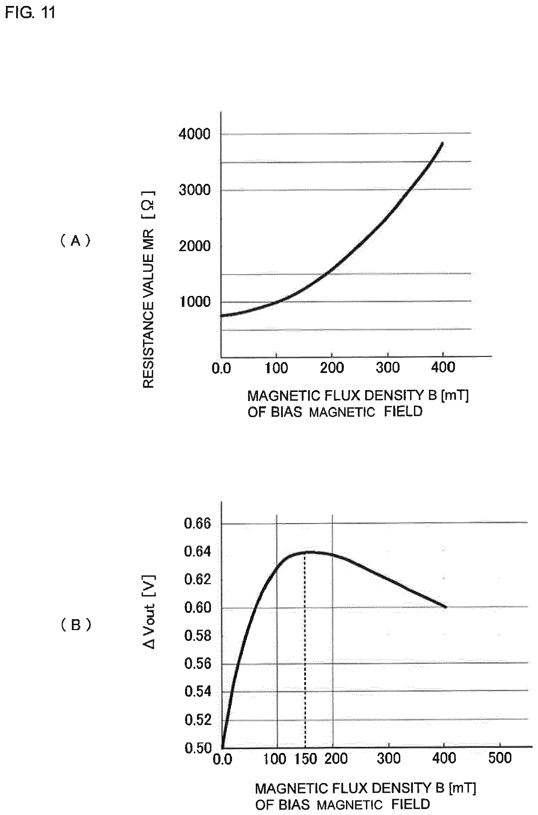

Fig. 11 (A) illustrates a characteristic of a resistance value to the magnetic flux density in the magnetic resistance element. Fig. 11 (B) illustrates a relationship between a bias magnetic field applied to the magnetic resistance element by the magnet and the output voltage of the magnetic sensor.

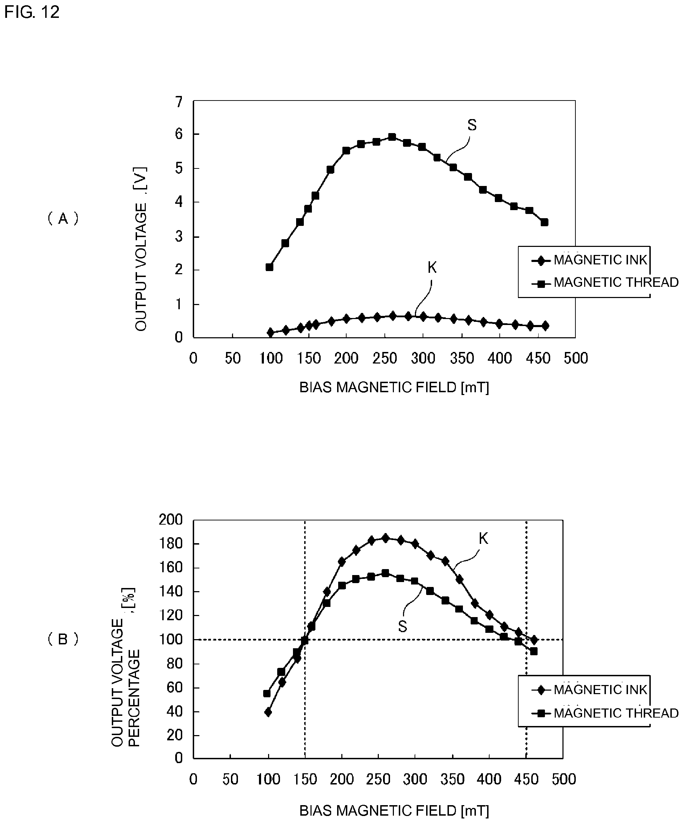

Fig. 12 includes illustrations of characteristics of the output voltage of the magnetic sensor to changes in the magnetic flux density of the bias magnetic field for different media.

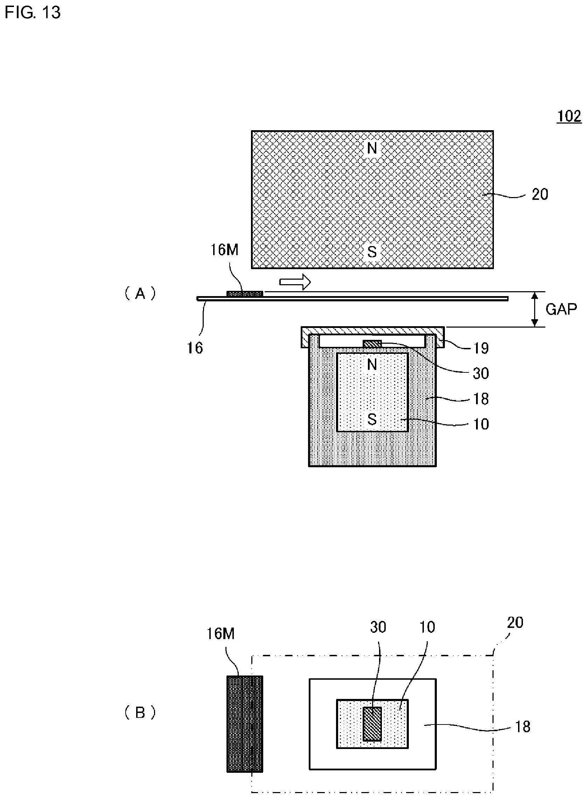

Fig. 13(A) is a cross-sectional view of a main portion in a magnetic sensor apparatus according to a second embodiment of the present invention. Fig. 13(B) is a plan view that illustrates a state where the yoke is removed from the magnetic sensor apparatus according to the second embodiment of the present invention.

Fig. 14 is a schematic diagram of a magnetic sensor apparatus illustrated in JP6-18278.

DESCRIPTION OF EMBODIMENTS

A magnetic sensor apparatus 101 according to an embodiment of the present invention is described with reference to the drawings in succession.

Fig. 1 is a cross-sectional view of a main portion in the magnetic sensor apparatus 101 according to the embodiment of the present invention. Figs. 2(A) to 2(D) are perspective views relating to the magnetic sensor apparatus 101 according to the embodiment of the present invention. The magnetic sensor apparatus 101 senses a magnetic pattern 16M on a medium 16 while the medium 16 is conveyed. The magnetic pattern 16M is formed by printing using magnetic ink being a magnetic substance.

In Fig. 1, the magnetic sensor apparatus 101 includes a magnetic sensor 100, an external holder 18E, and a yoke 20. The yoke 20 is a block member made of a pure iron-based soft magnetic material and is arranged above the magnetic sensor 100. The external holder 18E holds the magnetic sensor 100 and the yoke 20. The external holder 18E covers the outer periphery of the yoke 20.

The magnetic sensor 100 includes a plurality of magnetic resistance elements 30, a plurality of magnets 10, an internal holder 18C, and a cover 19. The magnets 10 apply a magnetic field to the magnetic resistance elements 30. The internal holder 18C holds the magnets 10. The magnetic resistance elements 30 are disposed on the upper portion of the internal holder 18C. The cover 19 is made of a non-magnetic metal, such as stainless steel, and covers the magnetic resistance elements 30. The magnetic sensor 100 is held by the external holder 18E such that the upper surface of the cover 19 is exposed and such that a part of the sides of the cover 19 and the sides of the internal holder 18C are covered with the external holder 18E.

The magnetic sensor apparatus 101 has a conveying portion (slit) 18S between the yoke 20 and the upper surface of the cover 19. The conveying portion (slit) 18S allows the medium 16 to be conveyed. Because the outer periphery of the yoke 20 is covered with the external holder 18E, the lower surface of the yoke 20 is covered with the external holder 18E, the lower surface being the opposite surface of the yoke 20 to the magnets 10. Thus the conveying portion (slit) 18S is located between the portion covering the lower surface of the yoke 20 in the external holder 18E and the upper surface of the cover 19. That is, the conveying portion 18S and the magnetic resistance elements 30 are arranged between the yoke 20 and the magnets 10. In the magnetic sensor apparatus 101, when each of the yoke 20 and the magnet 10 has a widthwise dimension along the conveying direction of the medium 16, the widthwise dimension of the yoke 20 is larger than that of the magnet 10. In the magnetic sensor apparatus 101, the opposite surface of the yoke 20 to the magnet 10 and the opposite surface of the magnet 10 to the yoke 20 are parallel to each other, and each of the magnetic resistance elements 30, more specifically, the magnetically sensitive portion in each of the magnetic resistance elements 30 is arranged in a position that is central in the conveying direction of the medium 16 between these opposite surfaces. In the magnetic sensor apparatus 101, a space G2 is narrower than a clearance G1 of the conveying portion 18S, where the space G2 is the space from the lower surface of the yoke 20 to the conveying portion 18S, the lower surface being the opposite surface of the yoke 20 to the magnet 10. The space G2 is the same as the thickness of the portion covering the lower surface of the yoke 20 in the external holder 18E.

Fig. 2(A) is a perspective view of the magnetic sensor 100. Fig. 2(B) is a transparent perspective view of the magnetic sensor apparatus 101 and illustrates a positional relationship between the magnetic sensor 100 and the yoke 20. In the Fig. 2(B), the external holder 18E is indicated by broken lines. Fig. 2(C) is a perspective view of the magnetic sensor apparatus 101. Fig. 2(D) illustrates a structure for conveying the medium 16.

As illustrated in Figs. 2(A) and 2(B), each of the magnetic sensor 100 and the yoke 20 has a long shape. One example of the medium 16 may be a banknote. As illustrated in Fig. 2(D), the medium 16 is conveyed while being pinched between upper and lower rollers 40.

Fig. 3 is a cut-away perspective view of the magnetic sensor 100. Fig. 3 illustrates a state where the cover 19 is removed in part. As illustrated in Fig. 3, the internal holder 18C has a plurality of recesses in its upper surface. The recesses are arranged in line along the longitudinal direction of the internal holder 18C. The magnetic resistance elements 30 (magnetic resistance elements 30a, 30b, 30c, 30d, ...) are housed in these recesses. The internal holder 18C has a plurality of recesses in its lower surface. The recesses are arranged in line along the longitudinal direction of the internal holder 18C. The magnets 10 are housed in these recesses.

Terminal pins electrically connected to the plurality of magnetic resistance elements 30a, 30b, 30c, 30d, ... are extended out from the lower portion of the internal holder 18C.

Fig. 4(A) is a plan view of the magnetic resistance element 30 and illustrates a state before the surface is covered with an insulating protective film. Fig. 4(B) is a circuit diagram of the magnetic sensor 100. Fig. 4(C) is a waveform diagram of an output voltage of the magnetic sensor 100 when the medium 16 is conveyed. As illustrated in Fig. 4(A), the magnetic resistance element 30 includes an input terminal Vin, an output terminal Vout, a ground terminal GND, and two kinds of element portions MR1 and MR2 whose magnetic resistance sections have different pattern shapes. As illustrated in Fig. 4(B), the magnetic resistance element 30 constitutes a resistance voltage divider circuit made up of the elements MR1 and MR2. As illustrated in Fig. 4(A), when the magnetic pattern 16M on the medium 16 passes over the magnetically sensitive portion in the magnetic resistance element 30, the voltage at the output terminal Vout (output voltage of the resistance voltage divider circuit) changes in a substantially inverted V shape in Fig. 4(C).

Fig. 5(A) is a plan view that illustrates a configuration of the element MR1. As illustrated in Fig. 5(A), the element MR1 includes magnetic resistance sections 31 and short bars 32. When the pitch of the magnetic resistance sections 31 and the short bars 32 is represented by L and the width of each of them is represented by W, the change ratio RB/R0 of the resistance value of the element MR1 to W/L, that is, the sensitivity of the element MR1 expresses the characteristic illustrated in Fig. 5(B). The resistance value RB is a value in a state where a magnetic field is applied by the magnets 10. The resistance value R0 is a value in a state where no magnetic field is applied by the magnet 10. In the magnetic sensor 100, the element MR2 has small W/L and low element sensitivity. Thus the magnetic resistance element 30 having the configuration illustrated in Fig. 4(A) is used, and the circuit configuration illustrated in Fig. 4(B) is employed. When the magnetic pattern 16M on the medium 16 passes over the magnetically sensitive portion in the magnetic resistance element 30, the output illustrated in Fig. 4(C) occurs.

A magnetic sensor illustrated in Figs. 6(A) to 6(C) according to a comparative example is prepared. The magnetic sensor according to the comparative example includes a magnetic resistance element illustrated in the plan view of Fig. 6(A). The configuration other than the magnetic resistance element in the magnetic sensor according to the comparative example is the same as that in the magnetic sensor 100 according to the present embodiment. Fig. 6(B) is a circuit diagram of the magnetic sensor according to the comparative example. Fig. 6(C) is a waveform diagram of an output voltage of the magnetic sensor according to the comparative example when the medium 16 is conveyed. As illustrated in Figs. 6(A) and 6(B), the magnetic resistance element is a so-called AC-type magnetic resistance element, includes an input terminal Vin, an output terminal Vout, a ground terminal GND, and two element portions MR1 and MR2 whose magnetic resistance sections have the same pattern shape, and constitutes a resistance voltage divider circuit made up of the elements MR1 and MR2. When the magnetic pattern 16M on the medium 16 passes over the magnetically sensitive portion in the magnetic resistance element, the voltage at the output terminal Vout (output voltage of the resistance voltage divider circuit) changes in the shape of a substantially inverted V and a substantially V, which have opposite changing directions, illustrated in Fig. 6(C).

Next, one specific quantitative example is described to compare the characteristics of the magnetic sensor apparatus between the present embodiment and comparative examples.

Fig. 7(A) illustrates dimensions of the yoke 20. Fig. 7(B) illustrates dimensions of sections of the magnetic resistance element 30 and the cover 19 and a positional relationship among them. Fig. 8(A) illustrates a strength distribution of a magnetic field in the magnetic sensor apparatus 101 according to the present embodiment using magnetic lines of force. Fig. 8(B) illustrates a strength distribution of a magnetic field in a magnetic sensor apparatus according to a first comparative example using magnetic liens of force. The magnetic sensor apparatus according to the first comparative example includes the magnetic sensor 100, as in the case of the magnetic sensor apparatus 101 according to the present embodiment, but does not include the yoke 20. Fig. 8(C) illustrates a strength distribution of a magnetic field in a magnetic sensor apparatus according to a second comparative example using magnetic liens of force. The magnetic sensor apparatus according to the second comparative example includes the magnetic sensor according to the comparative example illustrated in Fig. 6 and the yoke, as in the case of the magnetic sensor apparatus 101 according to the present embodiment.

As is clear from Fig. 8(A), the space between the magnetic resistance element 30 and the yoke 20 is wider than the space between the magnetic resistance element 30 and the magnet 10 in the magnetic sensor apparatus 101, and when each of the yoke 20 and the magnet 10 has a widthwise dimension along the conveying direction of the medium 16, the widthwise dimension of the yoke 20 is larger than that of the magnet 10. Thus a magnetic field is formed whose magnetic flux density is uniform in the direction of the clearance between the magnet 10 and the yoke 20 over a certain zone in the conveying direction of the medium 16 between the magnet 10 and the yoke 20. In the magnetic sensor apparatus 101, the space G2 from the lower surface of the yoke 20 to the conveying portion 18S is narrower than the clearance G1 of the conveying portion 18S (see Fig. 1), the lower surface of the yoke 20 being opposite to the magnet 10. Thus the space between the magnetically sensitive portion in the magnetic resistance element 30 and the yoke 20 can be reduced while the GAP, which is the space from the surface of the cover 19 to the magnetic pattern 16M, is ensured. Accordingly, the changes in the magnetic flux density in the conveying portion 18S to the variations in the GAP can be suppressed.

Fig. 9(A) is a waveform diagram of the output voltage of the magnetic sensor 100 when the medium 16 is conveyed in the magnetic sensor apparatus 101 according to the present embodiment. Fig. 9(B) is a waveform diagram of an output voltage of the magnetic sensor when a medium is conveyed in the magnetic sensor apparatus according to the first comparative example. Fig. 9(C) is a waveform diagram of an output voltage of the magnetic sensor when a medium is conveyed in the magnetic sensor apparatus according to the second comparative example. In Figs. 9(A) to 9(C), an output waveform WP0 is a waveform when the GAP, which is the space from the surface of the cover 19 to the magnetic pattern 16M on the medium 16 (see Fig. 1), is 0, and an output waveform WP1 is a waveform when the GAP is 1 mm.

As is clear from the comparison between Figs. 9(A) and 9(B), in both of the cases of GAP = 0 and GAP = 1 mm, the provision of the yoke 20, as in the magnetic sensor apparatus 101 according to the present embodiment, enables an increased peak value of the output voltage of the magnetic sensor 100.

Figs. 10(A) and 10(B) illustrate changes of a peak value of the output voltage of the magnetic sensor 100 to the GAP. C0 indicates a characteristic of the magnetic sensor apparatus according to the first comparative example. C1 indicates a characteristic of the magnetic sensor apparatus 101 according to the present embodiment when the space G0 from the surface of the cover 19 to the yoke 20 (see Fig. 1) is 3 mm. C2 indicates a characteristic of the magnetic sensor apparatus 101 according to the present embodiment when the space G0 is 2 mm. C3 indicates a characteristic of the magnetic sensor apparatus 101 according to the present embodiment when the space G0 is 1.1 mm. C4 indicates a characteristic of a magnetic sensor apparatus according to a third comparative example, the magnetic sensor apparatus including the magnetic sensor according to the comparative example illustrated in Fig. 6 and not including a yoke. C5 indicates a characteristic of the magnetic sensor apparatus according to the second comparative example. The vertical axis in Fig. 10(A) indicates the output voltage value. The vertical axis in Fig. 10(B) indicates the ratio with reference to GAP = 0.

The measurement conditions are described below.

[Magnet]

| | |
|---|---|
| Material: | ferrite magnet |
| Dimensions: | $5.5 \times 4 \times 5$ mm |
| Space to Magnetic Resistance Element: | 0.5 mm |
| Width of Sensing of Element: | 0.5 mm |
| Space between Element and Surface of Cover: | 0.4 mm |

[Yoke]

| | |
|---|---|
| Material: | iron (pure iron-based soft magnetic material) |
| Dimensions: | $40 \times 20 \times 10$ mm |
| G0: | 1.1 mm, 2 mm, 3 mm |

As is clear from Fig. 10(B), the provision of the yoke 20, as in the magnetic sensor apparatus 101 according to the present embodiment, can suppress the variations in the peak value of the output voltage to the changes in the GAP. It is revealed that improvement advantage achieved by the provision of the yoke is few in the magnetic sensor apparatuses including the magnetic sensor illustrated in Fig. 6 according to the comparative examples. This results from arrangement in which the elements MR1 and MR2 in the AC-type magnetic resistance element are in positions displaced from the central position in the conveying direction of the medium between the magnet and the opposite surface of the yoke toward the front and rear in the conveying direction of the medium. That is, the magnetic flux density in the position of each of these two elements MR1 and MR2 significantly varies with the changes in the GAP.

Fig. 11 (A) illustrates a characteristic of a resistance value to the magnetic flux density in the magnetic resistance element. Fig. 11 (B) illustrates a relationship between a bias magnetic field applied to the magnetic resistance element by the magnet and the output voltage of the magnetic sensor.

When the amount of change in the resistance caused by the passage of the magnetic pattern on the medium is represented by $\Delta$MR and the amount of change in the magnetic flux density caused by the passage of the magnetic pattern is represented by $\Delta$B, $\Delta$MR/$\Delta$B is the sensitivity of the magnetic resistance element. When the passage of the magnetic pattern changes the resistance of MR1 to MR1 + $\Delta$MR1, the output voltage of the magnetic sensor changes by

$$\Delta Vout = Vin*\{(MR1 + \Delta MR1) / (MR1 + MR2) - MR1 / (MR1 + MR2)\}$$

$$= Vin*\Delta MR1 / (MR1 + MR2).$$

The vertical axis in Fig. 11 (B) indicates this output voltage change $\Delta$Vout.

As illustrated in Fig. 11 (B), a peak occurs in the variations in the output voltage to the changes in the magnetic flux density of the bias magnetic field. In the range where the magnetic flux density of the bias magnetic field is lower than the magnetic flux density 150 [mT], at which the peak occurs, the amount of increase in (MR1 + MR2) is smaller than that in $\Delta$MR1. In the higher range, the amount of increase in (MR1 + MR2) is larger than that in $\Delta$MR1.

Fig. 12 includes illustrations of characteristics of the output voltage of the magnetic sensor to changes in the magnetic flux density of the bias magnetic field for different media. The vertical axis in Fig. 12(A) indicates the output voltage. The vertical axis in Fig. 12(B) indicates the output voltage ratio. The characteristic "S" indicates the one when the medium is a magnetic thread. The characteristic "K" indicates the one when the medium includes a magnetic pattern formed by printing using magnetic ink used in banknotes. In Fig. 12(B), the output voltage ratio is determined with reference to the output voltage when the bias magnetic field is 150 [mT].

As illustrated, the behavior of the output voltage of the magnetic sensor resulting from the bias magnetic field varies depending on the medium. Fig. 12(A) reveals that in the case of the medium including the magnetic pattern formed by printing using magnetic ink used in banknotes, sufficient output is not obtainable for 100 [mT]. Fig. 12(B) reveals that when the magnetic flux density of the bias magnetic field exceeds 450 [mT], the output voltage of the magnetic sensor is lower than that when the magnetic flux density is 150 [mT] (value at which a peak occurs in the variations in the output voltage of the magnetic sensor to the changes in the magnetic flux density of the bias magnetic field). Accordingly, the magnetic flux density of the bias magnetic field may preferably be in the range of 150 [mT] to 450 [mT].

In the case of the ferrite magnet, a magnetic flux density of only approximately 100 [mT] is obtainable at maximum. With the provision of the yoke 20, as in the magnetic sensor apparatus 101 according to the present embodiment, the magnetic flux density of the bias magnetic field in the magnetically sensitive portion in the magnetic resistance element 30 is no less than 150 [mT]. Thus even when the ferrite magnet is used as the magnet 10, the provision of the yoke 20 enables the magnetic flux density of the bias magnetic field to be set in the range of 150 [mT] to 450 [mT]. Accordingly, it is not necessary to use a high-cost magnet, such as a magnet containing a rare earth, for example, neodymium, and the low-cost ferrite magnet can be used.

Second Embodiment

Fig. 13(A) is a cross-sectional view of a main portion in a magnetic sensor apparatus 102 according to a second embodiment of the present invention. Fig. 13(B) is a plan view that illustrates a state where the yoke 20 is removed from the magnetic sensor apparatus 102 according to the present embodiment. The magnetic sensor apparatus 102 according to the present embodiment differs from the magnetic sensor apparatus 101 according to the first embodiment in that the magnet 10, the magnetic resistance element 30, and the cover 19 are disposed on the holder 18 and the yoke 20 is separated from the holder 18. The yoke 20 is magnetized in a direction in which the yoke 20 and the magnet 10 are attracted to each other.

As in this case, the yoke 20 may be separated from the magnet 10 and the magnetic resistance element 30. This increases the degree of freedom in the arrangement of the magnetic sensor 100. When the yoke 20 is magnetized in the direction in which the yoke 20 and the magnet 10 are attracted to each other, a magnetic field in which its magnetic flux density is uniform in the direction of the clearance between the magnet 10 and the yoke 20 is formed in the clearance therebetween in a wide range in the conveying direction of the medium 16 between the magnet 10 and the yoke 20. Additionally, magnetic charge caused by the magnet 10 and that by the yoke 20 are added together, and the magnetic flux density in the clearance between the magnet 10 and the yoke 20 is enhanced. Correspondingly, the clearance between the magnet 10 and the yoke 20 can be increased. The degree of freedom in the design of the structure for conveying the medium 16 can be enhanced, and a large quantity of media 16 can be easily conveyed at high speed.

Reference Signs List

MR1, MR2 magnetic resistance element
10 magnet
16 medium
16M magnetic pattern
18 holder
18C internal holder
18E external holder
18S conveying portion
19 cover
20 yoke
30 magnetic resistance element
30a, 30b, 30c, 30d magnetic resistance element
31 magnetic resistance section
32 short bar
100 magnetic sensor
101, 102 magnetic sensor apparatus

**Claims**

1. A magnetic sensor apparatus (101) comprising:

   a magnetic sensor (100) including a magnetic resistance element (30), a magnet (10), and a holder (18, C, E) on which the magnetic resistance element is disposed and that holds the magnet in a position where a magnetic field is applied to the magnetic resistance element, the magnetic sensor being configured to sense a magnetic substance included in a medium (16); and
   a yoke (20) arranged in a position opposite to the magnet (10) such that a conveying portion allowing the medium (16) to be conveyed and the magnetic resistance element (30) are disposed therebetween, wherein the yoke has an opposite surface to the magnet and the magnet has an opposite surface to the yoke,

   **characterized in that**
   each of the yoke (20) and the magnet (10) has a widthwise dimension along a conveying direction of the medium, and the widthwise dimension of the yoke on the opposite surface to the magnet is larger than the widthwise dimension of the magnet on the opposite surface to the yoke.

2. The magnetic sensor apparatus according to claim 1, wherein the opposite surfaces are parallel to each other, and the magnetic resistance element (30) is arranged in a position that is central in the conveying direction of the medium between the two opposite surfaces.

3. The magnetic sensor apparatus according to any one of claims 1 or 2, wherein the holder (18, C, E) holds the yoke (20).

4. The magnetic sensor apparatus according to any one of claims 1 to 3, wherein a space from the opposite surface of the yoke (20) to the magnet (10) to the conveying portion is narrower than a clearance of the conveying portion.

5. The magnetic sensor apparatus according to any one of claims 1 to 4, wherein the magnet (10) is a ferrite magnet.

6. The magnetic sensor apparatus according to any one of claims 1 to 5, wherein a magnetic flux density in a magnetically sensitive portion in the magnetic resistance element is in a range of 150 to 450 mT.

7. The magnetic sensor apparatus according to any one of claims 1 to 6, wherein the yoke (20) is magnetized in a direction in which the yoke and the magnet are attracted to each other.

# EP 2 816 368 B1

## Patentansprüche

1. Magnetsensorvorrichtung (101), die aufweist:

   einen Magnetsensor (100) mit einem Magnetwiderstandselement (30), einem Magneten (10) und einem Halter (18, C, E), auf dem das Magnetwiderstandselement angeordnet ist und der den Magneten in einer Position hält, wo ein Magnetfeld an das Magnetwiderstandselement angelegt wird, wobei der Magnetsensor zum Erfassen einer in einem Medium (16) enthaltenen magnetischen Substanz konfiguriert ist; und
   ein Joch (20), das in einer Position gegenüber dem Magneten (10) so angeordnet ist, dass ein Beförderungsteil, der das Befördern des Mediums (16) ermöglicht, und das Magnetwiderstandselement (30) dazwischen angeordnet sind, wobei das Joch eine dem Magneten gegenüberliegende Oberfläche hat und der Magnet eine dem Joch gegenüberliegende Oberfläche hat,
   **dadurch gekennzeichnet, dass**
   das Joch (20) und der Magnet (10) jeweils eine Querabmessung entlang einer Beförderungsrichtung des Mediums haben und die Querabmessung des Jochs an der dem Magneten gegenüberliegenden Oberfläche größer ist als die Querabmessung des Magneten an der dem Joch gegenüberliegenden Oberfläche.

2. Magnetsensorvorrichtung nach Anspruch 1, wobei die gegenüberliegenden Oberflächen parallel zueinander sind und das Magnetwiderstandselement (30) in einer Position angeordnet ist, die in der Beförderungsrichtung des Mediums zwischen den zwei gegenüberliegenden Oberflächen mittig ist.

3. Magnetsensorvorrichtung nach einem der Ansprüche 1 oder 2, wobei der Halter (18, C, E) das Joch (20) hält.

4. Magnetsensorvorrichtung nach einem der Ansprüche 1 bis 3, wobei ein Zwischenraum von der dem Magneten (10) gegenüberliegenden Oberfläche des Jochs (20) zum Beförderungsteil schmaler als ein Freiraum des Beförderungsteils ist.

5. Magnetsensorvorrichtung nach einem der Ansprüche 1 bis 4, wobei der Magnet (10) ein Ferritmagnet ist.

6. Magnetsensorvorrichtung nach einem der Ansprüche 1 bis 5, wobei eine magnetische Flussdichte in einem magnetisch empfindlichen Teil im Magnetwiderstandselement im Bereich von 150 bis 450 mT ist.

7. Magnetsensorvorrichtung nach einem der Ansprüche 1 bis 6, wobei das Joch (20) in einer Richtung magnetisiert ist, in der das Joch und der Magnet einander anziehen.

## Revendications

1. Appareil à capteur magnétique (101) comprenant :

   un capteur magnétique (100) comprenant un élément de résistance magnétique (30), un aimant (10) et un support (18, C, E) sur lequel l'élément de résistance magnétique est disposé et qui tient l'aimant dans une position où un champ magnétique est appliqué à l'élément de résistance magnétique, le capteur magnétique étant configuré pour détecter une substance magnétique incluse dans un article (16) ; et
   une culasse (20) arrangée dans une position opposée à l'aimant (10) de telle sorte qu'une partie de transport permettant à l'article (16) d'être transporté et l'élément de résistance magnétique (30) sont disposés entre eux, où la culasse a une surface opposée à l'aimant et l'aimant a une surface opposée à la culasse,

   **caractérisé en ce que**
   chacun d'entre la culasse (20) et l'aimant (10) a une dimension dans le sens de la largeur le long d'une direction de transport de l'article, et la dimension dans le sens de la largeur de la culasse sur la surface opposée à l'aimant est plus grande que la dimension dans le sens de la largeur de l'aimant sur la surface opposée à la culasse.

2. Appareil à capteur magnétique selon la revendication 1, dans lequel les surfaces opposées sont parallèles l'une à l'autre, et l'élément de résistance magnétique (30) est arrangé dans une position qui est centrale dans la direction de transport de l'article entre les deux surfaces opposées.

3. Appareil à capteur magnétique selon l'une quelconque des revendications 1 ou 2, dans lequel le support (18, C, E) tient la culasse (20).

4. Appareil à capteur magnétique selon l'une quelconque des revendications 1 à 3, dans lequel un espace de la surface opposée de la culasse (20) à l'aimant (10) jusqu'à la partie de transport est plus étroit qu'un dégagement de la partie de transport.

5. Appareil à capteur magnétique selon l'une quelconque des revendications 1 à 4, dans lequel l'aimant (10) est un aimant en ferrite.

6. Appareil à capteur magnétique selon l'une quelconque des revendications 1 à 5, dans lequel une densité de flux magnétique dans une partie magnétiquement sensible dans l'élément de résistance magnétique est dans une plage de 150 à 450 mT.

7. Appareil à capteur magnétique selon l'une quelconque des revendications 1 à 6, dans lequel la culasse (20) est magnétisée dans une direction dans laquelle la culasse et l'aimant sont attirés l'un vers l'autre.

FIG. 1

FIG. 2

（A）

（B）

（C）

（D）

FIG. 3

FIG. 4

16M

Vin    GND    30

MR1

MR2

Vout

(A)

(B)

Vin

MR2

Vout

MR1

GND

(C)

Vout

POSITION (TIME)

FIG. 5

（A）

（B）

32  31

W

L

ELEMENT
SENSITIVITY

（RB/R0）

0          W/L

FIG. 6

( A )

MR1

MR2

( B )

Vin

MR2

Vout

MR1

( C )

2.0
1.5
1.0
0.5
0.0
−0.5
−1.0
−1.5
−2.0

Vout mV

0    2    4    6    8    10

FIG. 7

（A）

10mm
40mm
20mm
20
G1
100

（B）

MAGNETICALLY
SENSITIVE PORTION
0.5mm
30
19
0.4mm
3mm
0.5mm
5mm
4mm
10

FIG. 8

( A )

20

MAGNETICALLY
SENSITIVE
PORTION

10

( B )

MAGNETICALLY
SENSITIVE
PORTION

10

( C )

MAGNETICALLY
SENSITIVE
PORTION

10

FIG. 9

（A）

（B）

（C）

FIG. 10

(A)

C3 ——— 1.1mm(W/ YOKE)
C2 ——— 2mm(W/ YOKE)
C1 ——— 3mm(W/ YOKE)
C0 ------- DC(W/O YOKE)
C4 —·—· AC(W/O YOKE)
C5 — — AC(W/ YOKE)

(B)

C3 ——— 1.1mm(W/ YOKE)
C2 ——— 2mm(W/ YOKE)
C1 ——— 3mm(W/ YOKE)
C0 ------- DC(W/O YOKE)
C4 —·—· AC(W/O YOKE)
C5 — — AC(W/ YOKE)

20

FIG. 11

(A)

(B)

FIG. 12

( A )

( B )

FIG. 13

102

16M

（A）

16

GAP

N
S
20

19
30
18
10

N
S

（B）

16M

30  10  20

18

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6018278 A
- EP 0662667 A
- WO 2012015012 A
- WO 2010052797 A